# EUROPEAN PATENT APPLICATION

(11) **EP 2 275 909 A2**
(43) Date of publication of application: **19.01.2011**
(21) Application number: 10167997.5
(22) Date of filing: 30.06.2010
(51) Int. Cl.: G06F 3/045

(54) **Touch panel and detecting method thereof**

(30) Priority: 30.06.2009 CN 200910303874
(71) Applicant: Chimei InnoLux Corporation, Chu-Nan 350 T'ai pei (TW)
(72) Inventor: Cheng, Jia-Shyong, Chu-Nan 350 (TW); Shih, Po-Sheng, Chu-Nan 350 (TW); Wu, Jeah-Sheng, Chu-Nan 350 (TW); Chao, Chih-Han, Chu-Nan 350 (TW)
(74) Representative: Gray, John James

(57) **Abstract**

A touch panel includes a first substrate (20), a second substrate (21), a first conductive film (22, 200) disposed on the first substrate, and a second conductive film (23, 201) disposed on the second substrate and juxtaposed with the first conductive film in a face-to-face manner. The second conductive film has a first resistivity in a first direction and a second resistivity in a second direction different from the first direction. The first resistivity is greater than the second resistivity.

## Description

### BACKGROUND

### 1. Technical Field

The present disclosure relates to a touch panel and a detecting method thereof, and more particularly to a touch panel that uses at least one conductive film exhibiting electric anisotropy and a detecting method thereof.

### 2. Description of Related Art

Touch panels are becoming widely used in electronic products, such as mobile phones and navigation systems, for example, to serve as input devices. A new trend of the touch panel technology is towards having a multi-touch detection ability. There are several types of touch panels including resistive type, capacitive type, infrared type, and surface acoustic wave type, for example Most of the touch panels that support multi-touch detection are capacitive type touch panels. However, the complexity of a driving method for driving a conventional capacitive type touch panel increases with the resolution of the capacitive type touch panel, and when more than two points on the capacitive type touch panel are touched by a user, the problem of incorrect results on the location of the user's touch determined by a detecting method implemented by the capacitive type touch panel tends to occur.

### SUMMARY

According to one aspect of this disclosure, a touch panel includes a first substrate, a second substrate, a first conductive film disposed on the first substrate, and a second conductive film disposed on the second substrate and juxtaposed with the first conductive film in a face-to-face manner. The second conductive film has a first resistivity in a first direction and a second resistivity in a second direction different from the first direction. The first resistivity is greater than the second resistivity.

According to another aspect of this disclosure, a detecting method adapted for detecting a user's touch on a touch panel is disclosed. The touch panel includes first and second conductive films insulated from each other and coupled electrically to each other through the user's touch. The second conductive film has a first resistivity in a first direction and a second resistivity in a second direction different from the first direction. The first resistivity is greater than the second resistivity. The second conductive film has two opposite sides substantially parallel to the first direction. One of the sides of the second conductive film has a plurality of measuring points. The detecting method includes: (a) applying a first voltage to the first conductive film; (b) applying a second voltage different from the first voltage to the a second side of the two opposite sides of the second conductive film; (c) measuring sequentially voltages at the different measuring points of said first side of the two opposite sides of the second conductive film; and (d) determining the location of the user's touch based on the voltages measured in step (c).

### BRIEF DESCRIPTION OF THE DRAWINGS

The components in the drawings are not necessarily drawn to scale, the emphasis instead being placed upon clearly illustrating the principles of at least one embodiment. In the drawings, like reference numerals designate corresponding parts throughout the various views.

Fig. 1 is a schematic sectional view of the first exemplary embodiment of a touch panel of the present disclosure.

Fig. 2 is a schematic view illustrating first and second layers of the first exemplary embodiment.

Fig. 3 is a plot illustrating measured voltages of the first exemplary embodiment under a condition where the touch panel of the first exemplary embodiment is not touched.

Fig. 4 is a schematic view illustrating a condition that three points on the touch panel of the first exemplary embodiment are touched.

Fig. 5 is a plot illustrating measured voltages of the first exemplary embodiment under the condition shown in Fig. 4.

Fig. 6 is a schematic view illustrating first and second layers of the second exemplary embodiment of a touch panel of the present disclosure.

Fig. 7 is a schematic view illustrating first and second layers of the third exemplary embodiment of a touch panel of the present disclosure.

Fig. 8 is a schematic view illustrating first and second layers of the fourth exemplary embodiment of a touch panel of the present disclosure.

### DETAILED DESCRIPTION

Reference will now be made to the drawings to describe various embodiments in detail.

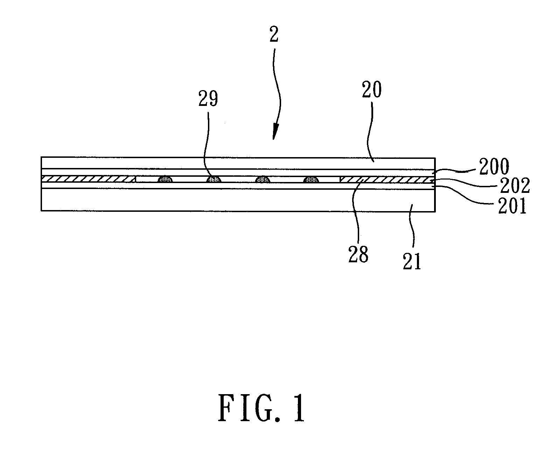

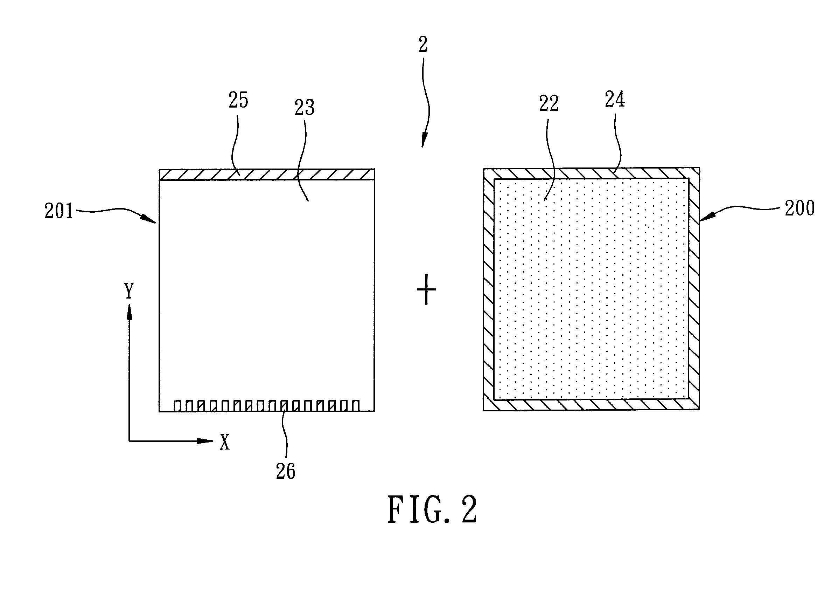

Referring to Figs. 1 and 2, the first exemplary embodiment of a touch panel 2 of the present disclosure includes a first substrate 20, a second substrate 21, a first conductive film 22, a second conductive film 23, a first electrode 24, a second electrode 25, a plurality of third electrodes 26, an adhesive film 28, and a plurality of spacers 29 of an insulator. The first substrate 20 is made from a flexible transparent material, such as polyethylene terephthalate (PET). The second substrate 21 is made from a rigid transparent material, such as glass. The first conductive film 22 and the first electrode 24 constitute a first layer 200 that is disposed on the first substrate 21. The second conductive film 23, the second electrode 25 and the third electrodes 26 constitute a second layer 201 that is disposed on the second substrate 21 and that is juxtaposed with the first layer 200 in a face-to-face manner. In one example, the distance between the first and second layers 200, 201 can range from 2 µm to 10 µm. The adhesive film 28 and the spacers 29 constitute a third layer 202 that is disposed between the first and second layers 200, 201. The adhesive film 28 extends along sides of the first and second layers 200, 201, and bonds the first and second layers 200, 201 together. The spacers 29 are spaced apart from each other, and are used to insulate the first and second layers 200, 201. It is noted that the spacers 29 can be removed as long as the first and second layers 200, 201 are separated from each other.

The first conductive film 22 is rectangular in shape, and is made from indium tin oxide (ITO) so as to have a low resistivity and a high transmittance. The first electrode 24 extends along sides of the first conductive film 22, and is coupled electrically to the first conductive film 22.

The second conductive film 23 is substantially transparent, exhibits electric anisotropy, has a first resistivity in a first direction (X) and a second resistivity in a second direction (Y) transverse to the first direction (X), and further has two opposite sides 23a, 23b substantially parallel to the first direction (X) and a sensing region (not labeled) extending between the two opposite sides 23a, 23b. The first resistivity is greater than the second resistivity in an extent such that the current will solely flow in the second direction (Y) when a voltage is applied across the two opposite sides 23a, 23b of the second conductive film 23. The first side 23a of the two opposite sides 23a, 23b of the second conductive film 23 has a plurality of measuring points (not labeled). The second electrode 25 has an elongated bar shape, is disposed at the second side 23b of the two oppsitie sides 23a, 23b of the second conductive film 23, and is coupled electrically to the second side 23 of the two opposite sides 23a, 23b of the second conductive film 23. The third electrodes 26 are uniformly disposed along said first side 23a of the two opposite sides 23a, 23b of the second conductive film 23, and are coupled electrically to the different measuring points (not labeled) of said first side 23a of the two opposite 23a, 23b sides of the second conductive film 23. As a consequence, a plurality of independent conductive channels extending respectively from the third electrodes 26 to the second electrode 25 in the second direction (Y) are allowed to be formed in the second conductive film 23.

In this embodiment, the second conductive film 23 can be made from a nanomaterial that has strings of interconnected carbon nanounits, with each string substantially extending in the second direction (Y). The adjacent ones of the carbon nanounits of each string are connected to each other through a Van der Waals' interaction therebetween. The structure of the second conductive film 23 results in a higher resistivity in the first direction (X) than that in the second direction (Y). Each of the carbon nanounits can be single-walled carbon nanotubes, double-walled carbon nanotubes, multi-walled carbon nanotubes, or any combination thereof. In one example, the second conductive film 23 has a uniform layer thickness ranging from about 0.5 nm to about 100 µm. Each of the single-walled carbon nanotubes has a diameter ranging from about 0.5 nm to about 50 nm. Each of the double-walled carbon nanotubes has a diameter ranging from about 1.0 nm to about 50 nm. Each of the multi-walled carbon nanotubes has a diameter ranging from about 1.5 nm to about 50 nm.

For example, when the second conductive film 23 has a length in the second direction (Y) that is smaller than 3.5 inches, the first resistivity is at least two times greater than the second resistivity, and when the second conductive film 23 has a length in the second direction (Y) that is greater than 3.5 inches, the first resistivity is at least five times greater than the second resistivity. The ratio of the first resistivity to the second resistivity increases with the length of the second conductive film 23 in the second direction (Y). In this embodiment, the second conductive film 23 has a length of 3.5 inches in the second direction (Y), and the first resistivity is at least ten times greater than the second resistivity.

For example, the first, second and third electrodes 24, 25, 26 are made from a material with a low resistivity, such as Al, Cu, or Ag, for example, so as to reduce attenuation of electric signals propagating therethrough. In this embodiment, the first, second and third electrodes 24, 25, 26 are made from a conductive silver ink.

The first exemplary embodiment of a detecting method of the present disclosure is adapted for detecting the user's touch on the touch panel 2, and includes the following steps: (a) applying a first voltage, such as 0 V, to the first conductive film 22 through the first electrode 24; (b) applying a second voltage, such as 10 V, different from the first voltage to the second side 23b of the two opposite sides 23a, 23b of the second conductive film 23 through the second electrode 25; (c) measuring sequentially voltages at the different measuring points (not labeled) of said first side 23a of the two opposite sides 23a, 23b of the second conductive film 23 through the third electrodes 26; and (d) determining the location of the user's touch based on the voltages measured in step (c). It is noted that, in this embodiment, each of the second electrodes 25 serves as an input terminal in step (b), while each of the third electrodes 36 serves as an output terminal in step (c).

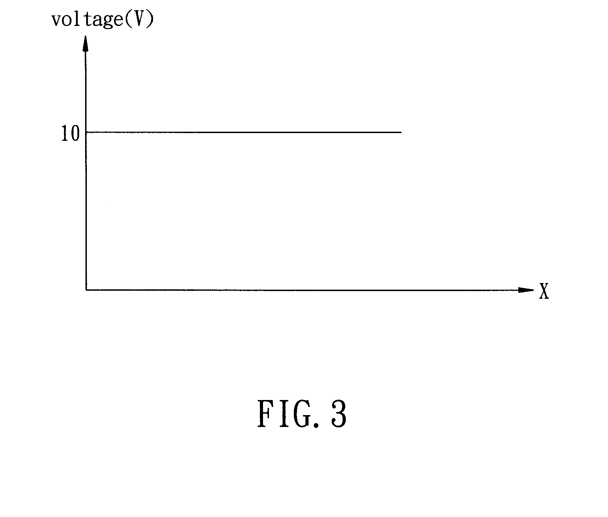

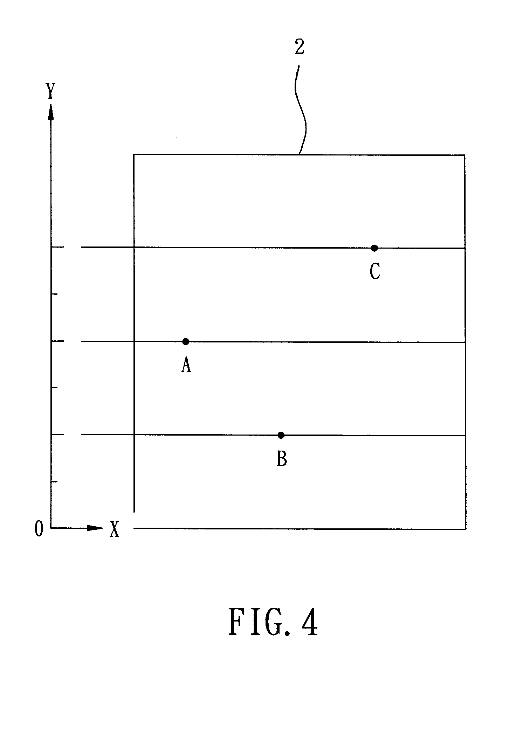

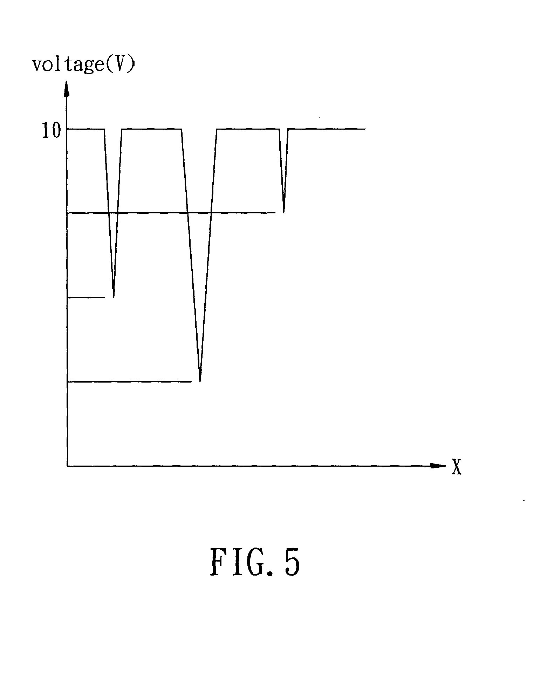

Referring to Figs. 2 and 3, when the touch panel 2 is not touched by the user, the first and second conductive films 22, 23 are insulated from each other, and the voltages measured at the third electrodes 26 are all equal to the second voltage, i.e., 10 V Referring to Figs. 2, 4 and 5, when three selected points (A, B, C) on the touch panel 2 are touched by the user (see Fig. 4), the first conductive film 22 is coupled electrically to the second conductive film 23 at the selected points (A, B, C) in the sensing region, and the voltages at the corresponding third electrodes 26 drop below the second voltage, i.e., 10 V, because of the application of the first voltage, i.e., 0V, through the first electrode 24 and the first conductive film 22 to the selected points (A, B, C) at the second conductive film 23 (see Fig. 5). The voltage drop at each of the third electrodes 26 with respect to the second voltage, i.e. 10 V, depends on the distance between the corresponding selected point and the second electrode 25, and increases with the distance. As shown in Figs. 4 and 5, the distance between the selected point (B) and the second electrode 25 is the largest, the voltage drop at the corresponding third electrode 26 is also the largest, while the distance between the selected point (C) and the second electrode 25 is the smallest, the voltage drop at the corresponding third electrode 26 is also the smallest.

Therefore, the locations of the selected points (A, B, C) in the first direction (X) can be determined according to the locations of the corresponding third electrodes 26 with voltages dropped below the second voltage, respectively. The locations of the selected points (A, B, C) in the second direction (Y) can be determined according to the magnitudes of the voltage drops at the corresponding third electrodes 26, respectively.

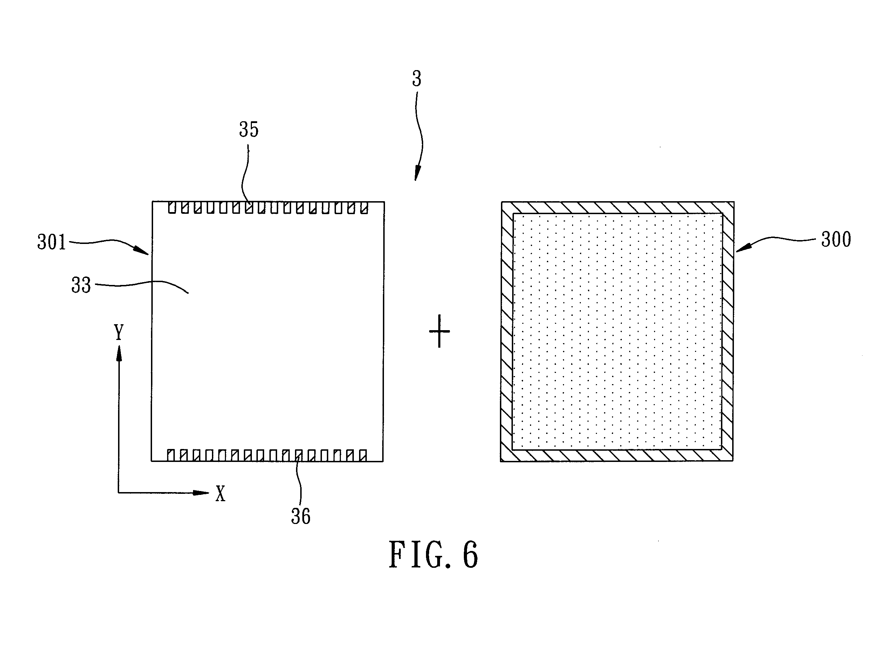

Referring to Fig. 6, the second exemplary embodiment of a touch panel 3 of the present disclosure differs from the first embodiment of the touch panel 2 (see Fig. 2) in that the second side 33b of the opposite sides 33a, 33b of the second conductive film 33 has a plurality of measuring points (not labeled), and that the touch panel 3 includes a plurality of second electrodes 35 disposed uniformly along the second side 33b of the opposite sides 33a, 33b of the second conductive film 33, coupled electrically to the different measuring points of said second side 33b of the sides 33a, 33b of the second conductive film 33, and aligned with the third electrodes 36 in the first direction (X), respectively. It is noted that only the first and second layers 300, 301 are shown in Fig. 6.

The second exemplary embodiment of a detecting method of the present disclosure is adapted for detecting a user's touch on the touch panel 3, and differs from the first embodiment of the detecting method in that this embodiment further includes the following steps: (e) applying the second voltage to said first side 33a of the opposite sides 33a, 33b of the second conductive film 33 through the third electrodes 36; and (f) measuring sequentially voltages at the different measuring points (not labeled) of the second side 33b of the opposite sides 33a, 33b of the second conductive film 33 through the second electrodes 35. The location of the user's touch is determined further based on the voltages measured in step (f) in addition to the voltages measured in step (c). Therefore, the location of the user's touch determined by this embodiment is more precise than that determined by the first embodiment. It is noted that, in this embodiment, each of the second electrodes 35 serves as an input terminal in step (b) and as an output terminal in step (f), while each of the third electrodes 36 serves as an input terminal in step (e) and as an output terminal in step (c).

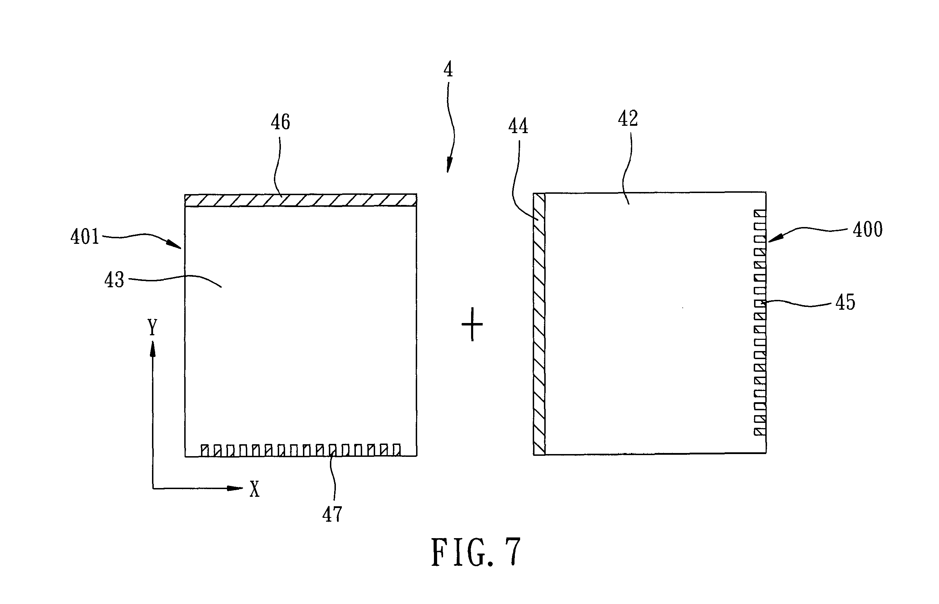

Referring to Fig. 7, the third exemplary embodiment of a touch panel 4 of the present disclosure differs from the first embodiment of the touch panel 2 (see Fig. 2) in that the first conductive film 42 is also made from the nanomaterial, but with each string substantially extending in the first direction (X). As such, the first conductive film 42 has a first resistivity in the first direction (X) and a second resistivity in the second direction (Y) greater than the first resistivity in an extent such that the current will solely flow in the first direction (X) when a voltage is applied across the opposite sides 42a, 42b of the first conductive film 42 which are substantially parallel to the second direction (Y). The first side 42a of the opposite sides 42a, 42b of the first conductive film 41 has a plurality of measuring points (not labeled). The touch panel 4 further includes: a first electrode 44 having an elongated bar shape, disposed at the second side 42b of the opposite sides 42a, 42b of the first conductive film 42, and coupled electrically to the second side 42b of the opposite sides 42a, 42b of the first conductive film 42; a plurality of second electrodes 45 uniformly disposed along the first side 42a of the opposite sides 42a, 42b of the first conductive film 42 and coupled electrically to the different measuring points (not labeled) of said first side 42a of the opposite sides 42a, 42b of the first conductive film 42; a third electrode 46 having an elongated bar shape, disposed at the second side 43b of the opposite sides 43a, 43b of the second conductive film 43, and coupled electrically to the second side 43b of the opposite sides 43a, 43b of the second conductive film 43; and a plurality of fourth electrodes 47 uniformly disposed along the first side 43a of the opposite sides 43a, 43b of the second conductive film 43 and coupled electrically to the different measuring points (not labeled) of the first side 43a of the opposite sides 43a, 43b of the second conductive film 43. The first conductive film 42, the first electrode 44 and the second electrodes 45 constitute the first layer 400, and the second conductive film 43, the third electrode 46 and the fourth electrodes 47 constitute the second layer 401. It is noted that only the first and second layers 400, 401 are shown in Fig. 7.

For instance, the first conductive film 42 has a substantially uniform layer thickness ranging from about 0.5 nm to about 100 µm. When the first conductive film 42 has a length in the first direction (X) that is smaller than 3.5 inches, the second resistivity of the first conductive film 42 is at least two times greater than the first resistivity of the first conductive film 42, and when the first conductive film 42 has a length in the first direction (X) that is greater than 3.5 inches, the second resistivity of the first conductive film 42 is at least five times greater than the first resistivity of the first conductive film 42. The ratio of the second resistivity of the first conductive film 42 to the first resistivity of the first conductive film 42 increases with the length of the first conductive film 42 in the first direction (X).

The third exemplary embodiment of a detecting method of the present disclosure is adapted for detecting a user's touch on the touch panel 4, and includes the steps of: (a) applying a first voltage, such as 0 V, to the first conductive film 42 through the first electrode 44 and/or the second electrodes 45; (b) applying a second voltage, such as 10 V, different from the first voltage to the second side 43b of the opposite sides 43a, 43b of the second conductive film 43 through the third electrode 46; (c) measuring sequentially voltages at the different measuring points of the first side 43a of the opposite sides 43a, 43b of the second conductive film 43 through the fourth electrodes 47; (d) determining the location of the user's touch in the first direction (X) based on the voltages measured in step (c); (e) applying the first voltage, i.e., 0 V, to the second conductive film 43 through the third electrode 46 and/or the fourth electrodes 47; (f) applying the second voltage, i.e., 10 V, to the second side 42b of the opposite sides 42a, 42b of the first conductive film 42 through the first electrode 44; (g) measuring sequentially voltages at the different measuring points of the first side 42a of the opposite sides 42a, 42b of the first conductive film 42 through the second electrodes 45; and (h) determining the location of the user's touch in the second direction (Y) based on the voltages measured in step (g).

In step (d) of this embodiment, the location of the user's touch in the first direction (X) can be determined according to the location of the corresponding fourth electrode 47 with a voltage dropped below the second voltage. In step (g) of this embodiment, the location of the user's touch in the second direction (Y) can be determined according to the location of the corresponding second electrode 45 with a voltage dropped below the second voltage. Therefore, the location of the user's touch can be determined without calculating the magnitudes of the voltage drops in this embodiment, which simplifies the method of this embodiment as compared to those of the first and second embodiments. In addition, the location of the user's touch determined by this embodiment is more precise than those of the first and second embodiments.

For example, in steps (c) and (g) of this embodiment, the voltages are measured in such a manner that while each of the measuring points is measured, a third voltage, such as 5 V, 10 V, or 0 V, for example, is applied to the rest of the measuring points through the corresponding second and/or fourth electrodes 45, 47 in order to eliminate an adverse effect on the measuring point caused by the rest of the measuring points and to thereby improve the accuracy of the measured voltage at the measuring point being measured.

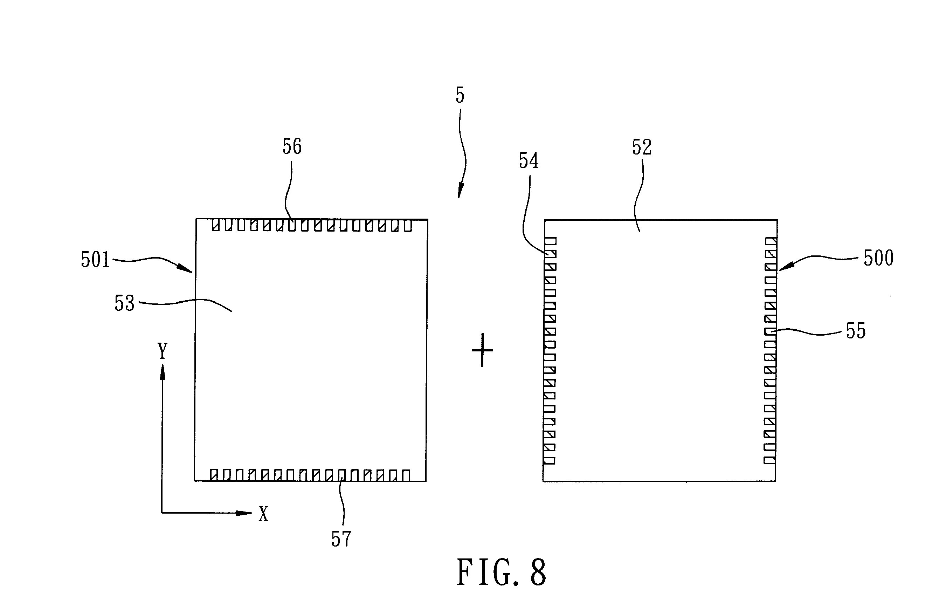

Referring to Fig. 8, the fourth exemplary embodiment of a touch panel 5 of the present disclosure differs from the third embodiment of the touch panel 4 (see Fig. 7) in that the touch panel 5 has a plurality of first electrodes 54 and a plurality of third electrodes 56, that the second side 52b of the opposite sides 52a, 52b of the first conductive film 52 has a plurality of measuring points (not labeled) , and that the second side 53b of the opposite sides 53a, 53b of the second conductive film 53 has a plurality of measuring points (not labeled). The first electrodes 54 are uniformly disposed along the second side 52b of the opposite sides 52a, 52b of the first conductive film 52, coupled electrically to the different measuring points (not labeled) of said second side 52b of the opposite sides 52a, 52b of the first conductive film 52, and aligned with the second electrodes 55 in the second direction (Y), respectively. The third electrodes 56 are uniformly disposed along the second side 53b of the opposite sides 53a, 53b of the second conductive film 53, coupled electrically to the different measuring points (not labeled) of the second side 53b of the opposite sides 53a, 53b of the second conductive film 53, and aligned with the fourth electrodes 57 in the first direction (X), respectively.

The fourth exemplary embodiment of a detecting method of the present disclosure is adapted for detecting a user's touch on the touch panel 5, and differs from the third embodiment of the detecting method in that this embodiment further includes the following steps: (i) applying the second voltage to said first side 53a of the opposite sides 53a, 53b of the second conductive film 53 through the fourth electrodes 57; (j) measuring sequentially voltages at the different measuring points (not labeled) of the second side 53b of the opposite sides 53a, 53b of the second conductive film 53 through the third electrodes 56; (k) applying the second voltage to said first side 52a of the opposite sides 52a, 52b of the first conductive film 52 through the second electrodes 55; and (1) measuring sequentially voltages at the different measuring points (not labeled) of the second side 52b of the opposite sides 52a, 52b of the first conductive film 52 through the first electrodes 54. The location of the user's touch in the first direction (X) is determined further based on the voltages measured in step (j) in addition to the voltages measured in step (c), and the location of the user's touch in the second direction (Y) is determined further based on the voltages measured in step (1) in addition to the voltages measured in step (g).

It is noted that the first conductive films 42, 52 and the second conductive films 23, 33, 43, 54 can also be made from a material other than the nanomaterial while still exhibit electric anisotropy properties, such as a conductive polymer, and a one-dimensional or two-dimensional crystalline material.

In summary, with the use of the first conductive films 42, 52 and the second conductive films 23, 33, 43, 54 exhibiting electrical anisotropy, the aforesaid embodiments have the following advantages: first, the structure of each of the touch panels 2, 3, 4, 5 is simple; second, the detection method implemented by each of the touch panels 2, 3, 4, 5 is simple; third, the problem of the aforesaid incorrect results on the location of the user's touch as encountered in the prior art can be overcome; and forth, each of the first conductive films 42, 52 and the second conductive films 23, 33, 43, 54 can be divided into independent conductive channels, so that the touch panels 2, 3, 4, 5 can support multi-touch detection, and the number of the touched points that can be correctly detected is unlimited theoretically. In addition, since each of the first conductive films 42, 52 and the second conductive films 23, 33, 43, 54 is made from the carbon nanounits, the touch panels 2, 3, 4, 5 thus formed have a high mechanical strength and a high transmittance.

It is to be understood that even though numerous characteristics and advantages of the present embodiments have been set forth in the foregoing description, together with details of the structures and functions of the embodiments, the disclosure is illustrative only; and that changes may be made in detail, especially in matters of shape, size, and arrangement of parts, within the principles of the embodiments, to the full extent indicated by the broad general meaning of the terms in which the appended claims are expressed.

## Claims

1. A touch panel comprising:
a first substrate;
a second substrate;
a first conductive film disposed on said first substrate; and
a second conductive film disposed on said second substrate and juxtaposed with said first conductive film in a face-to-face manner;
wherein said second conductive film has a first resistivity in a first direction and a second resistivity in a second direction different from the first direction; and
wherein said first resistivity is greater than said second resistivity.

2. The touch panel of claim 1, wherein said first resistivity is at least two times greater than said second resistivity.

3. The touch panel of claim 1, wherein said first resistivity is at least five times greater than said second resistivity.

4. The touch panel of any preceding claim, wherein said second conductive film is made from a nanomaterial.

5. The touch panel of claim 4, wherein said nanomaterial has a plurality of carbon nanounits.

6. The touch panel of claim 4 or 5, wherein said nanomaterial has strings of interconnected carbon nanounits, with each string substantially extending in the direction having the lower resistivities.

7. The touch panel of claim 6, further comprising:
a first electrode disposed on said first substrate and coupled electrically to said first conductive film.

8. The touch panel of claim 7, wherein said second conductive film has two opposite sides substantially parallel to the first direction, said touch panel further comprising:
at least one second electrode disposed on said second substrate and coupled electrically to a first side of said two opposite sides of said second conductive film; and
a plurality of third electrodes disposed on said second substrate and coupled electrically to a second side of said two opposite sides of said second conductive film.

9. The touch panel of any preceding claim, wherein said second conductive film has a layer thickness ranging from about 0.5 nm to about 100 µm.

10. The touch panel of any preceding claim, wherein said first conductive film has a first resistivity in the first direction and a second resistivity in the second direction, said second resistivity of said first conductive film being greater than said first resistivity of said first conductive film.

11. The touch panel of claim 10, wherein said second resistivity of said first conductive film is at least two times greater than said first resistivity of said first conductive film.

12. The touch panel of claim 10, wherein said second resistivity of said first conductive film is at least five times greater than said first resistivity of said first conductive film.

13. The touch panel of claim 10 11 or 12, wherein each of said first and second conductive films is made from a nanomaterial that has a plurality of carbon nanounits.

14. The touch panel of claim 10, 11, 12 or 13, wherein each of said first and second conductive films is made from a nanomaterial, said nanomaterial of said first conductive film having strings of interconnected carbon nanounits, with each string substantially extending in the first direction, said nanomaterial of said second conductive film having strings of interconnected carbon nanounits, with each string substantially extending in the second direction.

15. The touch panel of claim 14, wherein said first conductive film has two opposite sides substantially parallel to the second direction, said touch panel further comprising:
at least one first electrode disposed on said first substrate and coupled electrically to a first side of said two opposite sides of said first conductive film; and
a plurality of second electrodes disposed on said first substrate and coupled electrically to a second side of said two opposite sides of said first conductive film.

16. The touch panel of claim 15, wherein said second conductive film has two opposite sides substantially parallel to the first direction, said touch panel further comprising:
at least one third electrode disposed on said second substrate and coupled electrically to a first side of said two opposite sides of said second conductive film; and
a plurality of fourth electrodes disposed on said second substrate and coupled electrically to a second side of said two opposite sides of said second conductive film.

17. The touch panel of claim 14, 15 or 16, wherein each of said first and second conductive films has a layer thickness ranging from about 0.5 nm to about 100 µm.

18. The touch panel of any preceding claim, wherein said first conductive film is made from indium tin oxide.

19. The touch panel of any preceding claim, wherein at least one of said first and second conductive films is made from a conductive polymer.

20. A detecting method adapted for detecting a user's touch on a touch panel, the touch panel including first and second conductive films insulated from each other and coupled electrically to each other through the user's touch, the second conductive film having a first resistivity in a first direction and a second resistivity in a second direction different from the first direction, the first resistivity being greater than the second resistivity, the second conductive film having two opposite sides substantially parallel to the first direction, a first side of the two opposite sides of the second conductive film having a plurality of the measuring points, the detecting method comprising:
(a) applying a first voltage to the first conductive film;
(b) applying a second voltage different from the first voltage to a second side of the two opposite sides of the second conductive film;
(c) measuring sequential voltages at the different measuring points of said first side of the two opposite sides of the second conductive film; and
(d) determining the location of the user's touch based on the voltages measured in step (c).

21. The detecting method of claim 20, wherein in step (c), the voltages are measured in such a manner that while each of the measuring points is measured, a third voltage is applied to the rest of the first measuring points.

22. The detecting method of claim 20, the first conductive film having a first resistivity in the first direction and a second resistivity in the second direction, the second resistivity of the first conductive film being greater than the first resistivity of the first conductive film, the first conductive film having two opposite sides substantially parallel to the second direction, a third side of the two opposite sides of the first conductive film having a plurality of the measuring points, said detecting method further comprising:
(e) applying the first voltage to the second conductive film;
(f) applying the second voltage to the second side of the two opposite sides of the first conductive film;
(g) measuring sequential voltages at the different measuring points of said first side of the sides of the first conductive film; and
(h) determining the location of the user's touch based on the voltages measured in step (g).
